(19) Europäisches Patentamt
European Patent Office
Office européen des brevets

(11) Veröffentlichungsnummer : **0 135 616 B1**

(12) # EUROPÄISCHE PATENTSCHRIFT

(45) Veröffentlichungstag der Patentschrift : 28.03.90

(51) Int. Cl.$^5$ : G 03 F 7/021

(21) Anmeldenummer : 83112298.1

(22) Anmeldetag : 07.12.83

(54) **Lichtempfindliche Mischkondensate und damit hergestelltes lichtempfindliches Aufzeichnungsmaterial.**

(30) Priorität : 02.08.83 US 519443

(43) Veröffentlichungstag der Anmeldung : 03.04.85 Patentblatt 85/14

(45) Bekanntmachung des Hinweises auf die Patenterteilung : 28.03.90 Patentblatt 90/13

(84) Benannte Vertragsstaaten : CH DE FR GB LI

(56) Entgegenhaltungen :
BE-A- 894 612
DE-A- 2 024 244
FR-A- 2 493 547
GB-A- 2 029 592
US-A- 4 343 884

(73) Patentinhaber : HOECHST CELANESE CORPORATION
Route 202-206 North
Somerville, N.J. 08876 (US)

(72) Erfinder : Walls, John E.
46, Center Street
Annandale New Jersey 08801 (US)
Erfinder : Dunder, Thomas A.
15, Fine Road
High Bridge New Jersey 08829 (US)

(74) Vertreter : Euler, Kurt Emil, Dr. et al
KALLE Niederlassung der Hoechst AG Rheingaustrasse 190 Postfach 3540
D-6200 Wiesbaden 1 (DE)

EP 0 135 616 B1

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

## Beschreibung

Die vorliegende Erfindung betrifft lichtempfindliche Diazoniumsalz-Mischkondensate, die zur Herstellung von Flachdruckplatten und anderen photographischen Elementen, z. B. Photoresists und Farbprüffolien, verwendet werden können.

Bekanntlich unterscheiden sich Diazoniumverbindungen in ihrer Lichtempfindlichkeit und in ihren Alterungseigenschaften bzw. ihrer Lagerfähigkeit stark voneinander. Die Erfahrung hat gezeigt, daß sich Lichtempfindlichkeit und Lagerfähigkeit dabei umgekehrt proportional zueinander verhalten, d. h., mit zunehmender Lichtempfindlichkeit nimmt die Lagerfähigkeit ab und umgekehrt. Als Faustregel gilt, daß handelsübliche Druckplatten eine Lagerfähigkeit von mindestens 12, vorzugsweise jedoch von mindestens 18 Monaten haben müssen, ohne daß eine spürbare Abnahme ihrer lichtempfindlichkeit eintritt.

Eine Methode zur Erhöhung der Lagerfähigkeit besteht darin, eine hochlichtempfindliche Verbindung, die zunächst wasserlöslich ist, in eine lösemittellösliche Form zu überführen. Durch diesen Schritt wird die hygroskopische Natur der Verbindung abgeschwächt, durch die der Alterungsprozeß unerwünscht beschleunigt wird. Doch erhöht sich durch dieses Verfahren die Lichtempfindlichkeit der Verbindung nicht.

In der EP-A 89 509 wird ein Verfahren zur elektrochemischen Beschichtung eines metallischen Schichtträgers, vorzugsweise aus Aluminium, mit wasserlöslichen Diazoniumsalz-Polykondensationsprodukten beschrieben. Das Verfahren besteht darin, daß man zunächst die Oberfläche des Schichtträgers elektrolytisch hydrophiliert. Dabei wird der Träger als Anode geschaltet und in eine wäßrige Lösung einer wasserlöslichen organischen Säure, z. B. einer mehrbasigen Carbonsäure oder einer Phosphonsäure, gebracht. Danach wird der hydrophilierte Träger in eine wäßrige Lösung des Diazoniumsalz-Kondensationsprodukts gebracht und als Kathode geschaltet. Diese Art der Beschichtung hat den Vorteil, daß die Druckauflage von danach hergestellten Flachdruckplatten erhöht wird. Wenn jedoch bei diesem Verfahren besonders lichtempfindliche Kondensationsprodukte verwendet werden, so neigen die damit erhaltenen Druckplatten zu einer geringeren Lagerfähigkeit.

Aufgabe der Erfindung war es, neue lichtempfindliche Diazoniumsalz-Kondensationsprodukte vorzuschlagen, die sich durch eine Kombination von hoher Lichtempfindlichkeit mit guter Lagerfähigkeit auszeichnen, auch dann, wenn sie durch kathodische Abscheidung auf Schichtträger aufgebracht worden sind.

Gegenstand der Erfindung ist ein lichtempfindliches Polykondensationsprodukt aus wiederkehrenden Einheiten der Formeln $A_1$ und $A_2$

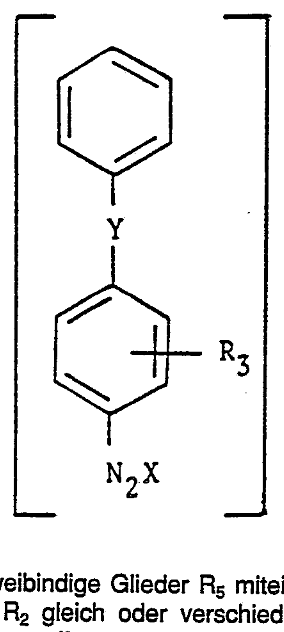

($A_1$) und

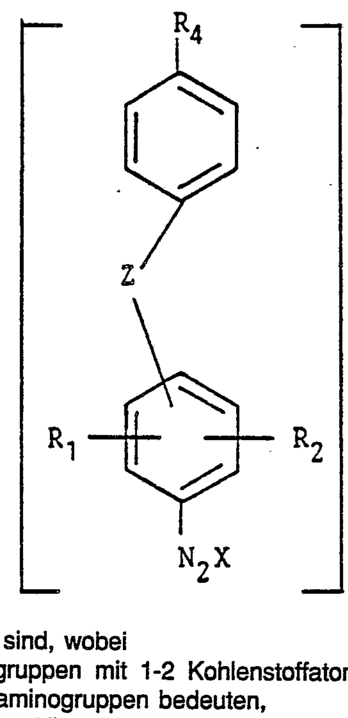

($A_2$)

die durch zweibindige Glieder $R_5$ miteinander verbunden sind, wobei

$R_1$ und $R_2$ gleich oder verschieden sind und Alkylgruppen mit 1-2 Kohlenstoffatomen, Alkoxygruppen mit 1-4 Kohlenstoffatomen, Halogenatome oder Dimethylaminogruppen bedeuten,

$R_3$ ein Wasserstoff- oder Chloratom, eine Methyl- oder Alkoxygruppe mit 1-2 Kohlenstoffatomen,

$R_4$ ein Wasserstoffatom, eine Methylgruppe oder ein Chloratom,

$R_5$ eine der Gruppen $—CH_2—$, $> CHCH_3$ und

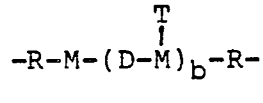

bedeutet, worin

R $CH_2$ oder $C(CH_3)_2$,

M der Rest eines aromatischen Kohlenwasserstoffs, eines Diarylethers, Diarylsulfids, Diaryldisulfids, Diarylsulfons, Diarylamins, Diarylketons oder Diaryldiketons,

D $—CH_2—$ oder $—CH_2—O—CH_2—$,

b Null oder eine Zahl von 1 bis 9 ist und

T ein Bindeglied der Bedeutung von R, ein Wasserstoffatom oder eine der Endgruppen 2-Hydroxy-prop-2-yl, Hydroxymethyl, ($C_1$-$C_4$-Alkoxy)methyl, Acetoxymethyl, Chlormethyl und Brommethyl ist, wen D = $—CH_2$ ist, und ein Wasserstoffatom ispt, wenn D = $—CH_2—O—CH_2—$ ist,

X das Anion des Diazoniumsalzes,

Y —NH—, $—SO_2—$ oder —O— und

Z —S—, —O— oder —NHCO— ist,

wobei im Mittel die Gesamtzahl der Einheiten $A_1 + A_2$ 2 bis 160 und das Verhältnis der Einheiten $A_1 : A_2$ 0,125-8 : 1 beträgt.

Erfindungsgemäß wird ferner ein lichtempfindliches Aufzeichnungsmaterial aus einem Schichtträger und einer lichtempfindlichen Schicht vorgeschlagen, die als lichtempfindliche Substanz ein Polykondensationsprodukt des oben angegebenen Aufbaus enthält.

Die Einheiten sind in dem erfindungsgemäßen Polykondensationsprodukt nicht in einer bestimmten Reihenfolge angeordnet.

Die Gesamtzahl der Einheiten $A_1 + A_2$ beträgt vorzugsweise 2 bis 30 und das Verhältnis ist vorzugsweise 0,5-2 : 1, insbesondere 0,5-1 : 1.

Wenn zwei Einheiten $A_2$ miteinander verbunden sind oder wenn eine Einheit $A_1$ mit einer Einheit $A_2$ verbunden ist, ist das Bindeglied bevorzugt $—CH_2$ oder $> CHCH_3$, insbesondere eine Methylengruppe.

$R_1$ ist bevorzugt eine Alkoxygruppe, Z eine Sulfidgruppe, Y eine NH-Gruppe und X ein Chlorid-, Sulfat- oder Phosphation.

Die erfindungsgemäßen lichtempfindlichen Diazoniumsalz-Kondensationsprodukte können im Gemisch mit weiteren Bestandteilen, wie Bindemitteln, Farbmitteln, Lösemitteln, Weichmachern, Netzmitteln und Säuren vorliegen, die je nach Bedarf hinzugefügt werden.

Die Verbindungen der vorliegenden Erfindung lassen sich allgemein als die Produkte von Kondensationsreaktionen beschreiben, bei denen zwei oder mehr Diazodiarylverbindungen mit Formaldehyd oder anderen geeigneten Kondensationspartnern umgesetzt werden, die befähigt sind, mit der Arylgruppe der monomeren Diazoverbindung zu kondensieren, die keine Diazogruppen enthält.

Die Reaktionsmedien sind dabei vorteilhafterweise Säuren, insbesondere anorganische Säuren, von denen wiederum Phosphor- oder Schwefelsäure bevorzugt wird.

Als monomere Diazoverbindungen eignen sich Diphenylamin-4-diazoniumsulfat, 3-Alkoxy-diphenylamin-4-diazoniumsulfat, 2,5-Dialkoxy-diphenylsulfid-4-diazoniumsulfat, 2,5-Dialkoxy-4-(p-tolylmercapto)-benzoldiazonium-tetrachlorozinkat, 2,5-Dialkoxy-4-benzoylamino-benzoldiazonium-tetrachlorozinkat oder 2-Chlor-5-(p-chlorphenoxy)-4-dimethylamino-benzoldiazoniumtetrachlorozinkat, wobei die Alkoxygruppen jeweils 1 bis 4 C-Atome haben. Als Kondensationspartner werden vorzugsweise Verbindungen der Formel $[4\text{-}(P\text{-}CH_2)phenyl]_2W$, worin W $—CH_2—$, —O—, —S—,

—S—S—, —NH—, —CO—, —CO—CO—, $CH_3\overset{|}{\underset{|}{C}}CH_3$, eine Gruppe der Bedeutung von M oder eine Einfachbindung sein kann und worin P —Cl, —Br, —OH, $—OCH_3$, $—OCH_2CH_3$, $—O(CH_2)_2CH_3$ oder $—O(CH_2)_3CH_3$ bedeutet, oder Paraformaldehyd verwendet. Oligomere, die zur Kondensation mit monomeren Diazoverbindungen verwendet werden, können die Homokondensate eines der vorstehend beschriebenen Kondensationspartner — außer Paraformaldehyd — oder deren Mischkondensate sein. Wenn die Kondensationsreaktion mit Paraformaldehyd als Kondensationspartner der Diazoverbindung durchgeführt wird, ist Schwefelsäure das bevorzugte Reaktionsmedium. Wenn monomere oder vorkondensierte Kondensationspartner der oben angegebenen Formeln verwendet werden, werden die Mischkondensationsreaktionen am besten in Phosphorsäure durchgeführt, unabhängig davon, ob Paraformaldehyd zugesetzt wird oder nicht. Bei Verwendung von Schwefelsäure beträgt die Konzentration der Säure bevorzugt 96 %, es sind jedoch auch geringere Konzentrationen möglich. Die Temperaturen können dabei vom Gefrierpunkt der Säure bis zu Raumtemperatur reichen, bevorzugt liegen sie zwischen etwa — 6 °C und + 15 °C, insbesondere zwischen 6 °C und 12 °C. Wenn die Kondensationsreaktion mit Phosphorsäure durchgeführt wird, ist im allgemeinen eine Konzentration von 85 % angemessen, doch kann die Konzentration auch wesentlich darunter liegen. In einigen Fällen ist zur Erreichung des gewünschten Ergebnisses eine erhöhte Aktivität erforderlich. Dann fügt man am besten $P_2O_5$ hinzu, um die Konzentration der Phosphorsäure zu steigern. Beim Einsatz von Phosphorsäure können die Temperaturen zwischen 10 °C und etwa 60 °C liegen, wobei Temperaturen zwischen 20 °C und 50 °C und insbesondere zwischen 35 °C und 45 °C bevorzugt werden.

Von den zur Herstellung der erfindungsgemäßen Kondensationsprodukte verwendeten monomeren Diazoniumverbindungen sollte eine bevorzugt eine Diarylsulfid-Diazoniumverbindung sein, die bevorzugt zwei Alkoxysubstituenten an dem Ring trägt, an dem sich die Diazoniumgruppe befindet.

Nach der Isolierung aus dem sauren Medium, in dem die Reaktion stattfindet, liegt das Endprodukt als das wasserlösliche Salz der verwendeten Säure vor. Falls die Reaktion in mehreren Stufen durchgeführt wird, handelt es sich dabei um das Salz der in der letzten Stufe verwendeten Säure.

Üblicherweise wird die monomere Diazoniumverbindung, bzw. werden die monomeren Diazoniumverbindungen in die zur Kondensation verwendete Säure gegeben; danach wird das als Kondensationspartner verwendete Monomere langsam hinzugefügt, so daß Temperaturschwankungen vermieden werden können. Es ist bekannt, daß die rasche Zugabe einer Diazoniumverbindung zu einem monomeren Kondensationspartner oder eines monomeren Kondensationspartners zu einer Diazoniumverbindung zu einer exothermen Reaktion führt, durch die ein unbrauchbares, teilweise zersetztes Endprodukt, entstehen kann, da es dann nicht möglich ist, die Temperatur genau zu kontrollieren. Falls keine weitere Umsetzung folgen soll, wird das Reaktionsprodukt aus der Säure isoliert, z. B. durch Ausfällen mittels Alkohol, danach mit Aktivkohle behandelt und schließlich als reines Produkt isoliert. Falls das erhaltene Produkt mit einer weiteren Diazoniumverbindung und einem weiteren monomeren Kondensationspartner umgesetzt werden soll, wird es isoliert und in der Säure gelöst, die für die nachfolgende Kondensationsreaktion verwendet werden soll, und in dieser Form weiterbehandelt. Die Reaktionszeit beträgt zwischen 5 und 300 Minuten, bevorzugt zwischen 30 und 250 Minuten und insbesondere zwischen 90 und 180 Minuten. Dieses Reaktionsprodukt wird ebenfalls mit Aktivkohle gereinigt und isoliert. Wenn ein monomerer oder oligomerer Kondensationspartner in eine Säure gegeben wird, die eine Diazoniumverbindung enthält, mit der dieses Monomere oder Oligomere reagieren soll, ist eine Nachreaktionszeit unter isothermen Bedingungen angezeigt, um die volle Umsetzung der Reaktionsteilnehmer sicherzustellen. Die Dauer der Nachreaktion kann zwischen 1/2 und 48 Stunden betragen. Bevorzugt beträgt sie 10 bis 30, insbesondere 12 bis 20 Stunden.

Wenn das fertige Diazoniumsalz-Kondensationsprodukt wasserlöslich sein soll, kann es als Salz der bei der Kondensationsreaktion verwendeten Säure isoliert werden, d. h. das Anion kann $HSO_4^-$, $H_2PO_4^-$, $Cl^-$ oder $Br^-$ sein. Soll das Produkt sowohl in Wasser als auch in organischen Lösemitteln löslich sein, so eignen sich als Anionen Methansulfonat, Sulfosalicylat und p-Toluolsulfonat. Die Löslichkeit in Lösemitteln wird durch Anionen wie z. B. Mesitylensulfonat und andere Arylsulfonate, $BF_4^-$ und $PF_6^-$ erreicht.

Lichtempfindliche Gemische, die zur Herstellung von lichtempfindlichen Materialien wie Flachdruckplatten, Photoresists oder Farbprüffolien verwendet werden, bestehen in der Regel aus einem Gemisch aus aromatischen Diazoniumsalzen, Bindemitteln, Farbstoffen oder Pigmenten, Indikatoren und Stabilisatoren, das auf einen geeigneten Träger, der im allgemeinen aus Aluminium besteht, aufgetragen wird.

Die erfindungsgemäßen Diazoniumverbindungen können ebenso wie die bekannten in wäßriger Lösung oder in organischen Lösemitteln verarbeitet werden, je nachdem, welches Anion sie enthalten. Die Menge der Diazoniumverbindung liegt zwischen 5 und 65, bevorzugt zwischen 15 und 50 und insbesondere zwischen 25 und 45 Gew.-%, bezogen auf den Gesamtfeststoffgehalt.

Der Diazoniumverbindung werden im allgemeinen Bindemittel zugesetzt, um die Druckauflage zu erhöhen. Zu solchen Bindemitteln gehören z. B. Polyurethane, Polyvinylacetale, Polyole, Polyacrylate, Polyvinylacetate und Phenolformaldehydharze. Sie werden gewöhnlich in Mengen zwischen 5 und 75, bevorzugt zwischen 15 und 60 und insbesondere zwischen 25 und 55 Gew.-%, bezogen auf den Feststoffgehalt des Beschichtungsgemischs, eingesetzt.

Als Farbmittel dienen gewöhnlich Pigmente oder Farbstoffe, wobei Pigmente bestimmte Vorteile haben. Zu den geeigneten Pigmenten gehören Phthalocyanin- und Anthrachinonpigmente. Der Farbmitteanteil liegt zwischen 2 und 35, bevorzugt zwischen 7 und 25 und insbesondere bei 10 bis 20 Gew.-%.

Stabilisatoren werden im allgemeinen verwendet, um die Lagerfähigkeit zu erhöhen, wenn das Beschichtungsgemisch zur Herstellung eines vorsensibilisierten lichtempfindlichen Materials dient. Zu derartigen Verbindungen gehören Citronensäure, p-Toluolsulfonsäure, Weinsäure und Phosphorsäure. In Abhängigkeit vom gewünschten Ergebnis schwankt ihr Anteil zwischen 0,5 und 15, bevorzugt zwischen 1,0 und 10 und insbesondere zwischen 2,5 und 5 Gew.-%.

Die obigen Ausführungen gelten für herkömmliche Beschichtungsverfahren. Sie gelten nicht für eine Beschichtung mittels kathodischer Abscheidung. Der Einsatz von elektrischem Strom schließt die Verwendung aller anderen Bestandteile außer den Diazoverbindungen aus. Aufgrund der unterschiedlichen Leitfähigkeit dieser Bestandteile ist es sehr schwierig, eine gleichmäßige Beschichtung zu erzielen. In einem solchen Verfahren werden daher die erfindungsgemäßen Diazoverbindungen als einziger Bestandteil in einer bevorzugt wäßrigen Lösung verwendet. Einige Lösemittel, wie Dimethylformamid oder Formamid, können allein oder bevorzugt im Gemisch mit entionisiertem Wasser eingesetzt werden. Wenn die Beschichtung mit Hilfe des elektrischen Stroms erfolgt, werden die Diazoverbindungen gewöhnlich in Mengen zwischen 0,1 Gew.-% und der Sättigungskonzentration der jeweiligen Verbindung, bevorzugt zwischen 0,5 und 5 Gew.-% und insbesondere in Mengen zwischen 1 und 3 Gew.-% verwendet.

Im folgenden wird die Erfindung anhand von Beispielen näher erläutert.

Herstellungsbeispiel 1 (Vergleich)

18 g Diphenylamin-4-diazoniumsulfat werden in 80 g konzentrierter Schwefelsäure gelöst und auf eine Temperatur von 6 °C eingestellt. Der Lösung werden innerhalb von 2 Stunden bei gleichbleibender

Temperatur langsam 1,9 g Paraformaldehyd zugegeben. Wenn die Zugabe des Paraformaldehyds beendet ist, wird das Reaktionsgemisch 16 Stunden lang stehen gelassen. Danach wird das Reaktionsprodukt als Sulfat isoliert. Die Ausbeute beträgt 18,7 g.

### Herstellungsbeispiel 2 (Vergleich)

Beispiel 1 wird wiederholt mit dem Unterschied, daß anstelle von Schwefelsäure Phosphorsäure verwendet wird und die Temperatur nicht bei 6 °C, sondern bei 42 °C gehalten wird. Die Zeiten und Gewichtsmengen bleiben unverändert. Das Reaktionsprodukt wird als Phosphat isoliert. Die Ausbeute beträgt 18,9 g. In beiden Fällen wird sorgfältig auf eine genaue Temperaturkontrolle geachtet.

### Herstellungsbeispiel 3 (Vergleich)

20 g 3-Methoxy-diphenylamin-4-diazoniumsulfat werden in 90 g Phosphorsäure gelöst. Dann wird die Temperatur auf 40 °C eingestellt und konstant gehalten. Innerhalb von 2 1/2 Stunden werden 14,7 g 4,4'-Bis-methoxymethyl-diphenylether langsam zugetropft. Das Reaktionsgemisch wird 17 Stunden lang stehen gelassen. Danach wird das Reaktionsprodukt als Phosphat isoliert. Die Ausbeute beträgt 32,9 g.

### Herstellungsbeispiel 4 (Vergleich)

25,1 g 4,4'-Bis-methoxymethyl-diphenylether werden in der gleichen Menge Phosphorsäure homokondensiert. Die Kondensationsreaktion findet bei einer gleichbleibenden Temperatur von 20 °C während 30 Minuten statt. Dieses Reaktionsgemisch wird innerhalb von 1 1/2 Stunden bei 40 °C langsam zu einer Lösung aus 20 g 3-Methoxy-diphenylamin-4-diazoniumsulfat und 90 g Phosphorsäure gegeben. Nach 17 Stunden Stehen wird das Reaktionsprodukt als Phosphat isoliert. Die Ausbeute beträgt 43,4 g.

### Herstellungsbeispiel 5

12 g Diphenylamin-4-diazoniumsulfat und 68,5 g 2,5-Dimethoxy-4-p-tolylmercapto-benzoldiazoniumtetrachlorozinkat werden zu 300 g konz. Schwefelsäure gegeben. Sobald alles unter gleichmäßigem Rühren bei 6 °C völlig gelöst ist, werden innerhalb von 2 Stunden 3,7 g Paraformaldehyd langsam hinzugefügt. Während dieser Zeit muß auf eine gleichbleibende Temperatur geachtet werden. Nach der Zugabe von Säure läßt man das Reaktionsgemisch 16 Stunden lang stehen, dann wird das Produkt als Sulfat isoliert. Die Ausbeute beträgt 78,6 g.

### Herstellungsbeispiel 6

15 g Diphenylamin-4-diazoniumsulfat werden in 60 g konz. Phosphorsäure gelöst. Die Temperatur wird auf 42 °C eingestellt. In dieses Gemisch werden innerhalb von 3 Stunden langsam 13,3 g 4,4'-Bis-methoxymethyl-diphenylether gegeben. Es ist darauf zu achten, daß während dieser Zeit die Temperatur konstant gehalten wird. Nach beendigter Zugabe läßt man das Reaktionsgemisch 17 Stunden stehen; daraufhin wird das Produkt als Phosphat isoliert. Die erhaltene Verbindung (Ausbeute 26,3 g) wird anschließend in 110 g konz. Schwefelsäure gelöst. Nach völliger Auflösung wird die Temperatur auf 10 °C eingestellt; danach werden 28,5 g 2,5-Dibutoxy-4-p-tolylmercapto-benzoldiazoniumtetrachlorozinkat zugegeben und ebenfalls aufgelöst. Innerhalb von 2 Stunden werden sodann 1,5 g Paraformaldehyd langsam zugetropft, wobei größte Sorgfalt darauf zu richten ist, die Temperatur von 10 °C konstant zu halten. Nach Zugabe der gesamten Paraformaldehydmenge läßt man das Gemisch 16 Stunden lang stehen. Das Produkt wird dann als Sulfat in einer Ausbeute von 54,7 g isoliert.

### Herstellungsbeispiel 7

16 g 2-Chlor-5-(p-chlorphenoxy)-4-dimethylamino-benzoldiazoniumtetrachlorozinkat werden in konz. Schwefelsäure gegeben. Die Lösung wird auf 10 °C eingestellt. Dann werden 9,9 g Diphenylamin-4-diazoniumsalz hinzugefügt. Nach dessen völliger Auflösung wird 1 g Paraformaldehyd innerhalb von 2 Stunden bei gleichbleibender Temperatur langsam zugetropft. Das Gemisch läßt man dann 18 Stunden stehen; anschließend wird das Reaktionsprodukt als Sulfat in einer Ausbeute von 25,5 g isoliert.

### Herstellungsbeispiel 8

15 g des in Beispiel 3 beschriebenen Reaktionsproduktes werden in 60 g konz. Schwefelsäure gelöst. Zu diesem Gemisch werden 7,5 g 2,5-Dibutoxy-4-p-tolylmercapto-benzoldiazoniumtetrachlorozinkat gegeben. Das Gemisch wird auf 10 °C eingestellt. Dann werden 0,5 g Paraformaldehyd innerhalb von 2 Stunden langsam zugetropft. Das erhaltene Gemisch läßt man 17 Stunden stehen. Das Reaktionsprodukt wird als Sulfat isoliert. Die Ausbeute beträgt 21,7 g.

Anwendungsbeispiele 9 bis 24

In den folgenden Beispielen werden die Ergebnisse, die unter Verwendung der in den Beispielen 1 bis 8 beschriebenen Produkte erzielt werden, tabellarisch dargestellt. Bei Beschichtung durch Tauchen wird eine 1-gew.-%ige Lösung von Raumtemperatur verwendet. Die Behandlungsdauer beträgt 60 Sekunden.

Bei der kathodischen Abscheidung wird eine 1-gew.-%ige Lösung der zu prüfenden Diazoniumverbindung in ein Gefäß gegeben, in dem sich im Abstand von je 5 cm von einer Aluminiumplatte zwei Bleianoden befinden. Die Aluminiumplatte dient als Kathode, und es wird eine 30 V-Gleichspannung angelegt.

Die zu beschichtende Aluminiumplatte wird erhalten, indem die geätzte und gereinigte Oberfläche einer Platte aus 3003-Aluminiumlegierung in einer Lösung von 10 g Polyvinylphosphonsäure je Liter Wasser elektrolytisch behandelt wird. Das Aluminium wird als Anode geschaltet und eine 30 V-Gleichspannung angelegt, bis ein Schichtgewicht von ca. 350 mg/m$^2$ erhalten worden ist.

Bei beiden Verfahren werden die Platten nach der Behandlung gründlich abgespült und trockengerieben.

Anwendungsbeispiele 9 bis 24

| Beispiel | Diazoverb. aus Beisp. | Verfahren | Belichtung mJ/cm$^2$ * | Alterung ** | Auflage x10$^{-3}$ | Erkennbare Fehler |
|---|---|---|---|---|---|---|
| 9 | 1 | Tauchen | 218 | 240 | - | leicht schwaches Bild |
| 10 | 1 | kathodische Abscheidung | 113 | 295 | - | Niederschlag an Anode |
| 11 | 2 | Tauchen | 239 | 265 | 6 | keine |
| 12 | 2 | kathodische Abscheidung | 120 | 310 | 70 | Niederschlag an Anode |
| 13 | 3 | Tauchen | 102 | 170 | - | keine |
| 14 | 3 | kathodische Abscheidung | 20 | 205 | - | Zerfall in Lösung |
| 15 | 4 | Tauchen | 14 | 50 | - | schwaches Bild |
| 16 | 4 | kathodische Abscheidung | 9 | 90 | - | Zerfall in Lösung |
| 17 | 5 | Tauchen | 136 | 265 | 15 | keine |
| 18 | 5 | kathodische Abscheidung | 24 | 305 | 105 | keine |
| 19 | 6 | Tauchen | 51 | 270 | - | keine |
| 20 | 6 | kathodische Abscheidung | 10 | 295 | - | keine |
| 21 | 7 | Tauchen | 154 | 215 | - | keine |
| 22 | 7 | kathodische Abscheidung | 47 | 235 | - | keine |
| 23 | 8 | Tauchen | 46 | 255 | 14 | keine |
| 24 | 8 | kathodische Abscheidung | 12 | 280 | 115 | keine |

* Benötigte Belichtungsenergie zur Erzielung von 6 gedeckten Stufen auf einem 21-Stufen Stauffer-Keil, nach subtraktiver Entwicklung und Einfärben.

** Lagerzeit in Minuten bei 100 °C, bis der Hintergrund tont. Die Platte sollte die Behandlung mindestens 120 Minuten lang unbeschadet überstehen. Das entspricht einer Lagerzeit von etwa 1 Jahr.

Anwendungsbeispiel 25

Das Herstellungsbeispiel 1 wird, wie beschrieben, bis zum Stehenlassen des Reaktionsgemisches einschließlich wiederholt; danach wird das Reaktionsgemisch in 600 ml Wasser gegeben und das Produkt als p-Toluolsulfonat ausgefällt. Das ausgefällte Produkt wird isoliert und getrocknet. Die Ausbeute beträgt 17,3 g.

Bei dem Versuch, eine 1 gewichtsprozentige Lösung der Diazoniumverbindung in Ethylenglykolmonomethylether herzustellen, erweist sich die Diazoniumverbindung als nicht ausreichend löslich. Eine 1 %-ige Lösung in entionisiertem Wasser läßt sich dagegen gut herstellen. Die wäßrige Lösung der Diazoniumverbindung wird auf eine mit einer Quarzaufschlämmung aufgerauhte, anodisch oxidierte und nach bekannten Verfahren hydrophilierte Aluminiumplatte aufgeschleudert. Nach dem Trocknen der Beschichtung wird die Platte mit einer Quecksilberdampflampe mit insgesamt 300 mJ/cm$^2$ belichtet. Die Platte wird nur mit Leitungswasser entwickelt und zum Drucken auf einer Bogenoffsetmaschine eingesetzt. Die so hergestellte Plattenkopie zeigt eine vollständig gedeckte Stufe 5 auf dem 21-stufigen Staufferkeil, und die Platte liefert 12.000 einwandfreie Drucke.

Anwendungsbeispiel 26

Das Herstellungsbeispiel 1 wird noch einmal wiederholt mit dem Unterschied, daß anstelle von Diphenylamin-4-diazoniumsulfat hier 2,5-Diethoxy-4-tolylmercapto-benzoldiazoniumtetrachlorozinkat verwendet wird. Das mit Paraformaldehyd bei 6 °C in Schwefelsäure kondensierte Produkte wird 16 Stunden stehen gelassen, dann in 600 ml entionisiertes Wasser gegeben und als p-Toluolsulfonat ausgefällt. Das ausgefällte Produkt wird isoliert und getrocknet. Die Ausbeute beträgt 17,6 g.

Bei dem Versuch, eine 1 gewichtsprozentige Lösung der Diazoniumverbindung in entionisiertem Wasser herzustellen, erweist sich die Diazoniumverbindung als nicht ausreichend löslich. Eine 1 %-ige Lösung in Ethylenglykolmonomethylether läßt sich dagegen herstellen. Die Lösung aus Lösemittel und Diazoniumverbindung wird auf eine mit einer Quarzaufschlämmung aufgerauhte, anodisch oxidierte und nach bekannten Verfahren hydrophilierte Aluminiumplatte aufgeschleudert. Nach dem Trocknen der Beschichtung wird die Platte mit einer Quecksilberdampflampe mit insgesamt 300 mJ/cm$^2$ belichtet. Die Platte wird nur mit Leitungswasser entwickelt und zum Drucken auf einer Bogenoffsetmaschine eingesetzt. In der Plattenkopie ist eine vollständig gedeckte Stufe 7 auf dem 21-stufigen Staufferkeil zu erkennen, der Hintergrund tont jedoch stark. Wegen des Tonens an den Nichtbildstellen kann die Auflagenhöhe nicht ermittelt werden.

Anwendungsbeispiel 27

Das Herstellungsbeispiel 5 wird, wie beschrieben, bis einschließlich Stehenlassen des Reaktionsgemisches wiederholt. Danach wird das Reaktionsgemisch in 3 l entionisiertem Wasser gelöst und als p-Toluolsulfonat ausgefällt.

Eine 1 gewichtsprozentige Lösung kann sowohl in entionisiertem Wasser als auch in Ethylenglykolmonomethylether hergestellt werden. Die Lösung aus Lösemittel und Diazoniumverbindung wird auf eine mit einer Quarzaufschlämmung aufgerauhte, anodisch oxidierte und nach bekannten Verfahren hydrophilierte Aluminiumplatte aufgeschleudert. Nach dem Trocknen der Beschichtung wird die Platte mit einer Quecksilberdampflampe mit insgesamt 300 mJ/cm$^2$ belichtet. Die Platte wird nur mit Leitungswasser entwickelt und zum Drucken auf einer Bogenoffsetmaschine eingesetzt. Die Kopie zeigt 9 vollständig gedeckte Stufen auf dem 21-stufigen Staufferkeil. Mit der Platte können mehr als 50.000 einwandfreie Drucke hergestellt werden.

Aus den vorstehenden Beispielen werden die Vorteile der vorliegenden Erfindung ersichtlich. In den Beispielen 9 bis 16 werden bekannte Diazoverbindungen eingesetzt. In den Beispielen 17 bis 24 wird mit den erfindungsgemäßen Diazoverbindungen gearbeitet. Unabhängig von der jeweils verwendeten Diazoverbindung haben Platten, die mittels kathodischer Abscheidung hergestellt werden, eine längere Lagerfähigkeit, eine höhere Auflage und Lichtempfindlichkeit als ihre Gegenstücke, die durch Tauchen beschichtet wurden.

Ein Vorteil der erfindungsgemäßen Mischkondensate gegenüber den herkömmlichen Verbindungen ist ihre größere Stabilität bei elektrochemischer Beschichtung. In den Beispielen 10, 12, 14 und 16 war entweder eine Ausfällung oder ein Zerfall zu verzeichnen, wogegen in den Beispielen 18, 20, 22 und 24 keinerlei Erscheinungen dieser Art auftraten.

Der Vergleich der Beispiele 24 und 18 mit Beispiel 12 und der Beispiele 23 und 17 mit Beispiel 11 zeigt, daß die neuen Verbindungen erheblich höhere Druckauflagen erbringen.

Die Beispiele 9 bis 16 zeigen ferner, daß mit zunehmender Lichtempfindlichkeit die Lagerfähigkeit der Platten mit bekannten Diazoniumverbindung sinkt. Die Beispiele 17 bis 24 zeigen hochlichtempfindliche Platten bei zugleich guter Lagerfähigkeit.

In Beispiel 25 wird nur eine monomere Diazoniumverbindung vom Typ A zur Kondensation verwendet, die zu einer geringen Druckauflage der damit hergestellten Druckplatte führt. In Beispiel 26 wird eine Diazoniumverbindung vom Typ A eingesetzt, wobei die Druckplatte sich nicht mit Wasser

entwickeln läßt. Beispiel 27 verwendet eine kondensierte Diazoniumverbindung mit Einheiten vom Typ $A_1$ und $A_2$; die damit hergestellte Druckplatte läßt sich mit Wasser entwickeln und liefert eine hohe Auflage.

## Patentansprüche

1. Lichtempfindliches Polykondensationsprodukt aus wiederkehrenden Einheiten der Formeln $A_1$ und $A_2$

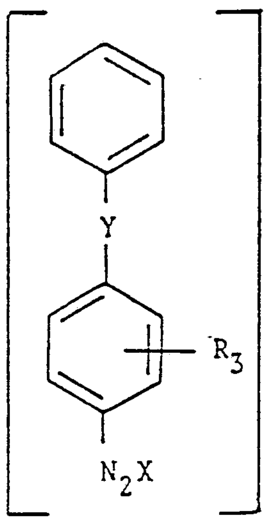

($A_1$) und

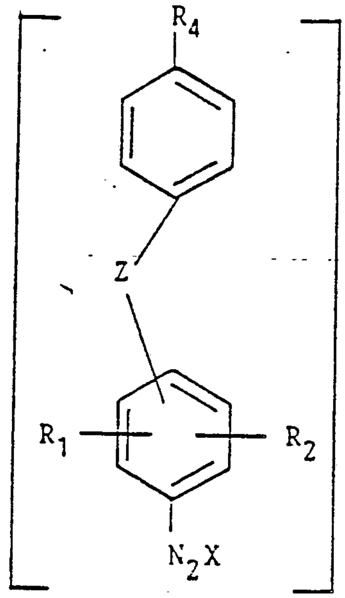

($A_2$)

die durch zweibindige Glieder $R_5$ miteinander verbunden sind, wobei

$R_1$ und $R_2$ gleich oder verschieden sind und Alkylgruppen mit 1-2 Kohlenstoffatomen, Alkoxygruppen mit 1-4 Kohlenstoffatomen, Halogenatome oder Dimethylaminogruppen bedeuten,

$R_3$ ein Wasserstoff- oder Chloratom, eine Methyl- oder Alkoxygruppe mit 1-2 Kohlenstoffatomen,

$R_4$ ein Wasserstoffatom, eine Methylgruppe oder ein Chloratom,

$R_5$ eine der Gruppen $—CH_2—$, $> CHCH_3$ und

$$-R-M-(D-\overset{\overset{\large T}{|}}{M})_b-R-$$

bedeutet, worin

R $CH_2$ oder $C(CH_3)_2$,

M der Rest eines aromatischen Kohlenwasserstoffs, eines Diarylethers, Diarylsulfids, Diaryldisulfids, Diarylsulfons, Diarylamins, Diarylketons oder Diaryldiketons,

D $—CH_2—$ oder $—CH_2—O—CH_2—$,

b Null oder eine Zahl von 1 bis 9 ist und

T ein Bindeglied der Bedeutung von R, ein Wasserstoffatom oder eine der Endgruppen 2-Hydroxy-prop-2-yl, Hydroxymethyl, ($C_1$-$C_4$-Alkoxy)methyl, Acetoxymethyl, Chlormethyl und Brommethyl ist, wenn D = $—CH_2$ ist, und ein Wasserstoffatom ist, wenn D = $—CH_2—O—CH_2—$ ist,

X das Anion des Diazoniumsalzes,

Y $—NH—$, $—SO_2—$ oder $—O—$ und

Z $—S—$, $—O—$ oder $—NHCO—$ ist,

wobei im Mittel die Gesamtzahl der Einheiten $A_1 + A_2$ 2 bis 160 und das Verhältnis der Einheiten $A_1 : A_2$ 0,125 — 8 : 1 beträgt.

2. Kondensationsprodukt nach Anspruch 1, dadurch gekennzeichnet, daß Y eine NH-Gruppe ist.

3. Kondensationsprodukt nach Anspruch 1, dadurch gekennzeichnet, daß Z die Gruppe $—S—$ ist.

4. Kondensationsprodukt nach Anspruch 1, dadurch gekennzeichnet, daß

$$R_5 = -R-M-(D-\overset{\overset{\large T}{|}}{M})_b-R-$$

D = $CH_2$ und

M der Rest eines Diphenylethers ist.

5. Lichtempfindliches Aufzeichnungsmaterial aus einem Schichtträger und einer lichtempfindlichen Schicht, die als lichtempfindliche Substanz ein Polykondensationsprodukt gemäß Anspruch 1 enthält.

6. Aufzeichnungsmaterial nach Anspruch 5, dadurch gekennzeichnet, daß die lichtempfindliche Schicht ferner ein polymeres Bindemittel enthält.

7. Aufzeichnungsmaterial nach Anspruch 5, dadurch gekennzeichnet, daß der Schichtträger aus Aluminium besteht.

## Claims

1. Photosensitive polycondensation product comprising recurring units of the formulae $A_1$ and $A_2$

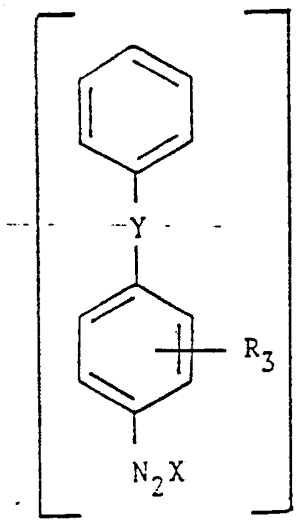

($A_1$), and

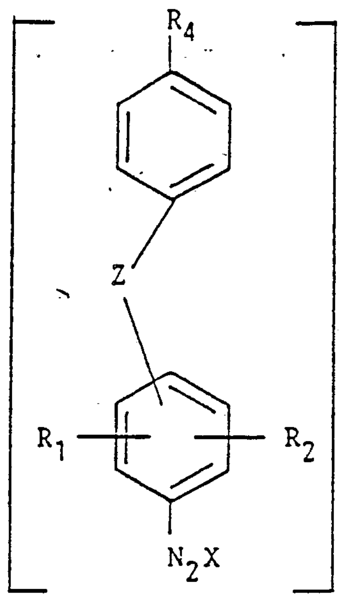

($A_2$)

which are connected to one another by divalent members $R_5$, where

$R_1$ and $R_2$ are identical or different and denote alkyl groups having 1-2 carbon atoms, alkoxy groups having 1-4 carbon atoms, halogen atoms or dimethylamino groups,

$R_3$ denotes a hydrogen or chlorine atom, or a methyl or alkoxy group having 1-2 carbon atoms,

$R_4$ denotes a hydrogen atom, a methyl group or a chlorine atom,

$R_5$ denotes one of the groups $-CH_2-$, $> CHCH_3$ and

$$-R-M-(D-\overset{T}{\overset{|}{M}})_b-R-$$

in which

R is $CH_2$ or $C(CH_3)_2$,

M is the radical of an aromatic hydrocarbon, of a diaryl ether, of a diaryl sulphide, of a diaryl disulphide, of a diaryl sulphone, of a diarylamine, of a diaryl ketone or of a diaryl diketone,

D is $-CH_2-$ or $-CH_2-O-CH_2-$,

b is zero or a number from 1 to 9, and

T is a connecting member with the meaning of R, a hydrogen atom or one of the end groups 2-hydroxyprop-2-yl, hydroxymethyl, ($C_1$-$C_4$-alkoxy)-methyl, acetoxymethyl, chloromethyl and bromomethyl when D is $-CH_2$, and is a hydrogen atom when D is $-CH_2-O-CH_2-$,

X is the anion of the diazonium salt,

Y is $-NH-$, $-SO_2-$ or $-O-$, and

Z is $-S-$, $-O-$ or $-NHCO-$,

the total number of units $A_1 + A_2$ being on average 2 to 160 and the ratio between the units $A_1 : A_2$ being 0.125 — 8 : 1.

2. Condensation product according to Claim 1, characterized in that Y is an NH group.

3. Condensation product according to Claim 1, characterized in that Z is the group $-S-$.

4. Condensation product according to Claim 1, characterized in that

$$R_5 = -R-M-(D-\overset{T}{\overset{|}{M}})_b-R-$$

$D = CH_2$ and

M is the radical of a diphenyl ether.

5. Photosensitive recording material comprising a coating base and a photosensitive coating which contains, as a photosensitive substance, a polycondensation product according to Claim 1.

6. Recording material according to Claim 5, characterized in that the photosensitive coating furthermore contains a polymeric binder.

7. Recording material according to Claim 5, characterized in that the coating base comprises aluminium.

**Revendications**

1. Produit de polycondensation photosensible constitué de motifs répétitifs de formules $A_1$ et $A_2$

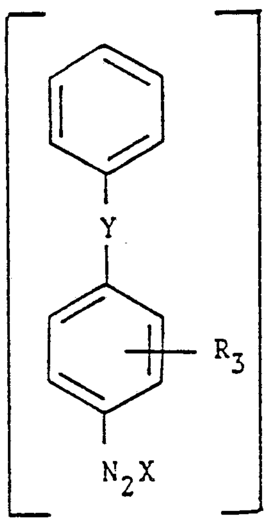

($A_1$) et

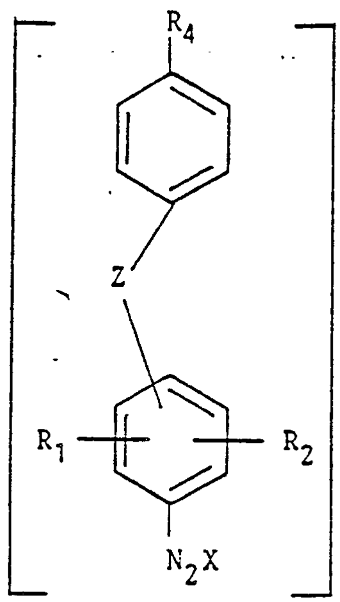

($A_2$)

qui sont reliés les uns aux autres par des chaînons bivalents $R_5$, dans lesquelles formules

$R_1$ et $R_2$ sont identiques ou différents et représentent des groupes alkyle ayant 1-2 atomes de carbone, des groupes alcoxy ayant de 1 à 4 atomes de carbone, des atomes d'halogène ou des groupes diméthylamino,

$R_3$ représente un atome d'hydrogène ou de chlore, le groupe méthyle ou un groupe alcoxy ayant 1-2 atomes de carbone,

$R_4$ représente un atome d'hydrogène ou de chlore ou le groupe méthyle,

$R_5$ représente l'un des groupes $—CH_2—$, $> CHCH_3$ et

$$-R-M-(D-\overset{T}{\overset{|}{M}})_b-R-$$

R représentant $—CH_2$ ou $C(CH_3)_2$,

M étant le reste d'un hydrocarbure aromatique, d'un éther diarylique, d'un sulfure de diaryle, d'un disulfure de diaryle, d'une diarylsulfone, d'une diarylamine, d'une diarylcétone ou d'une diaryldicétone,

D représentant $—CH_2$ ou $—CH_2—O—CH_2—$,

b étant zéro ou un nombre de 1 à 9, et

T étant un chaînon pontant ayant la même signification que R, un atome d'hydrogène ou l'un des groupes terminaux 2-hydroxy-prop-2-yle, hydroxyméthyle, alcoxy ($C_1$-$C_4$)-méthyle, acétoxyméthyle, chlorométhyle ou bromométhyle lorsque $D = —CH_2$, ou un atome d'hydrogène lorsque $D = —CH_2—O—CH_2—$,

X représente l'anion du sel de diazonium,

Y est $—NH—$, $—SO_2—$ ou $—O—$ et

Z est $—S—$, $—O—$ ou $—NHCO—$,

le nombre total des motifs $A_1 + A_2$ allant de 2 à 160 et le rapport des motifs $A_1 : A_2$ allant de 0,125 : 1 à 8 : 1, en moyenne.

2. Produit de condensation selon la revendication 1, caractérisé en ce que Y est le groupe NH.

3. Produit de condensation selon la revendication 1, caractérisé en ce que Z est —S—.

4. Produit de condensation selon la revendication 1, caractérisé en ce que

$$R_5 = -R-M-(D-\overset{T}{\overset{|}{M}})_b-R-$$

$D = CH_2$ et

M est le reste d'un éther diphénylique.

5. Matériau reprographique photosensible constitué d'un support de couche et d'une couche photosensible qui contient en tant que substance photosensible un produit de polycondensation selon la revendication 1.

6. Matériau reprographique selon la revendication 5, caractérisé en ce que la couche photosensible contient en outre un liant polymère.

7. Matériau reprographique selon la revendication 5, caractérisé en ce que le support de couche est constitué d'aluminium.